# EUROPÄISCHE PATENTSCHRIFT

(11) **EP 0 499 075 B1**
(45) Veröffentlichungstag und Bekanntmachung des Hinweises auf die Patenterteilung: **30.03.1994**
(21) Anmeldenummer: 92101203.5
(22) Anmeldetag: 25.01.1992
(51) Int. Cl.: H01L 31/05

(54) **Verfahren und Vorrichtung zur Herstellung eines Solarzellenstrings**
Method and apparatus for manufacturing a solar cell string
Procédé et dispositif pour fabriquer une suite de cellules solaires

(30) Priorität: 12.02.1991 DE 4104160
(43) Veröffentlichungstag der Anmeldung: 19.08.1992
(73) Patentinhaber: Nukem GmbH, D-63754 Alzenau (DE)
(72) Erfinder: Bende, Günter, W-8755 Alzenau (DE); Hoffmann, Winfried, Dr. Dipl.-Phys., W-6450 Hanau 7 (DE); Liesenfeld, Manfred, W-8755 Alzenau (DE); Luthardt, Günther, Dr. Dipl.-Chem., W-6458 Rodenbach (DE)
(74) Vertreter: Stoffregen, Hans-Herbert, Dr. Dipl.-Phys.

(56) Entgegenhaltungen:
- DE-A- 2 139 850
- DE-A- 2 826 789
- DE-A- 3 423 172
- US-A- 3 833 426

## Beschreibung

Die Erfindung bezieht sich auf eine Vorrichtung zum Verschalten eines Solarzellenstrings sowie auf ein Verfahren zur Herstellung eines Solarzellenstrings nach den Oberbegriffen der nebengeordneten Ansprüche 1 und 6.

Um Solarzellenmodule zur Verfügung zu stellen, werden Solarzellenstrings benötigt, die ihrerseits aus einzelnen Solarzellen einer Fläche von z. B. 10 x 10 cm² bestehen. Die Solarzellenstrings selbst werden zu dem Solarzellenmodul zusammengestellt. Solarzellenmodule können Abmessungen von derzeit typisch 1,0 m x 0,5 m aufweisen. Die Solarzellenmodule können Teile von Solarzellenfeldern bilden, mit denen Leistungen von z. B. 100 W bis zu mehreren 100 kW erzeugt werden.

Da mit den Solarzellenmodulen elektrische Energie gewonnen wird, ist es erforderlich, daß die zu den Solarzellenstrings verschalteten Solarzellen bei der Verschaltung und auch bei der späteren Benutzung insbesondere mechanischen Beanspruchungen Stand halten, daß also verhindert wird, daß die zum Verschalten der einzelnen Solarzellen benötigten vorzugsweise streifenförmig ausgebildeten Kontaktelemente beschädigt werden.

Es ist bereits bekannt, Kontaktstreifen zwischen zwei zu verschaltenden Solarzellen wellenförmig verlaufen zu lassen (DE-A-31 24 581, EP-A-0 115 803). Maßnahmen, den Verlauf kontrolliert zu verändern, sind jedoch nicht vorgesehen.

Der US-A-4,430,519 ist ein Verfahren und eine Vorrichtung zur Herstellung eines Solarzellenstrings zu entnehmen. Dabei liegt ein in den Ebenen der Solarzellen bzw. zwischen diesen verlaufender Kontaktstreifen zeitweise an einem Werkzeugteil an, das bis in die Ebene der Solarzellenunterseite veischiebbar ist.

Ein Verfahren und eine Einrichtung zur Verbindung von Kontakten an Solargeneratoren ist aus der DE-A-21 39 850 bekannt. Mit Hilfe eines Impuls-Lasers werden Kontaktelemente, die teilweise von Schweißschablonen aufgenommen sind, mit Solarzellen verbunden. Ausgleichsbögen der Kontaktelemente werden in Aussparungen der Schablone aufgenommen.

Der vorliegenden Erfindung liegt die Aufgabe zugrunde, eine Vorrichtung und ein Verfahren zur Herstellung eines Solarzellenstrings sowie einen solchen selbst so weiterzubilden, daß auf einfache Weise ein kontrollierter Verlauf des Kontaktelements derart sichergestellt ist, daß bei mechanischen Belastungen, also insbesondere einer Relativbewegung von aufeinanderfolgenden Solarzellen ausgeschlossen ist, so daß das diese verbindende Kontaktelement nicht beschädigt werden kann. Dabei sollen die Vorrichtung bzw. das Verfahren zur Herstellung eines Solarzellenstrings ermöglichen, daß mit einfachen Maßnahmen Solarzellen insbesondere in einer Montagestraße in Reihe zu verschalten sind.

Die Aufgabe wird durch die den Kennzeichen der Ansprüche 1 und 6 zu entnehmenden Maßnahmen gelöst. Ausgestaltungen ergeben sich aus den jeweiligen Unteransprüchen.

Durch diese Maßnahmen ist die Möglichkeit gegeben, die Kontaktelemente wie - streifen zwischen den Solarzellen derart verlaufen zu lassen, daß eine hinreichende Relativbewegung zwischen den Solarzellen möglich ist, ohne daß die Gefahr eines Beschädigens wie Reißens erwächst.

Dadurch, daß das zwischen den Solarzellen angeordnete Element, über das das Kontaktelement beim Kontaktieren mit der Solarzelle gespannt wird, die Länge zwischen den zu verschalteten Kontaktzellen vorgibt, ist ein reproduzierbarer Verlauf sichergestellt, ohne daß es im eigentlichen Sinne auf die Länge des insgesamt zur Verfügung stehenden Kontaktelements ankommt. Selbstverständlich muß das Kontaktelement so lang sein, daß es noch auf den zu verschaltenden Solarzellenflächen kontaktiert werden kann.

Das Element selbst ist vorzugsweise als anhebbarer bzw. absenkbarer Nocken ausgebildet.

In weiterer Ausgestaltung ist vorgesehen, daß die zu verschaltenden Solarzellen in einer eine Führung bildenden Vertiefung einer Aufnahme verschiebbar angeordnet sind. Auf diese Weise ist ein sicheres Entlangbewegen der Solarzellen an dem bzw. den Elementen, über die die Kontaktstreifen gelegt werden, sichergestellt.

Ein weiterer vorzuhebender Vorschlag sieht vor, daß einzelne Solarzellen in jeweils angepaßten Aufnahmen angeordnet sind und daß zwischen zwei Aufnahmen jeweils ein den Verlauf von zumindest einem Kontaktelement vorgebendes Element angeordnet ist.

Durch diese Maßnahme ist eine eindeutige Fixierung der Solarzellen zu dem den Verlauf des Kontaktstreifens vorgebenden Element gewährleistet.

Um auf einfache Weise und sukzessiv Solarzellen zu verschalten, ist vorgesehen, daß aufeinanderfolgend zu beiden Seiten des Elementes zu verschaltende Solarzellen angeordnet werden, wobei die zuletzt verschaltete Solarzelle bei der nachfolgenden Verschaltung mit einer weiteren Solarzelle in die Position der zuvor verschalteten Solarzelle bewegt wird. Durch diese Maßnahmen ist nur ein Element wie Nocken erforderlich, durch das das zwischen den verschalteten Solarzellen verlaufenden Kontaktelement eine gezielte Länge erhält.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines der Zeichnung zu entnehmenden bevorzugten Ausführungsbeispiels.

Es zeigen:
- Fig. 1: eine Draufsicht eines Ausschnittes eines Solarzellenstrings,
- Fig. 2: eine Schnittdarstellung entlang der Linie II-II in Fig. 1
- Fig. 3: im Ausschnitt und in vergrößerter Darstellung zwei in Reihe zu verschaltende Solarzellen mit zwischen diesen verlaufendem Kontaktstreifen gewünschter Länge und
- Fig. 4: in Draufsicht eine Aufnahme für zu verschaltende Solarzellen.

In den Fig., in denen gleiche Elemente mit gleichen Bezugszeichen versehen sind, sind Solarzellen (10), (12), (14) rein prinzipiell dargestellt, die in Reihe zu einem Solarzellenstring (16) verschaltet worden sind. Bei den Solarzellen (10), (12) und (14) handelt es sich um solche üblicher Bauart, die aus einkristallinen oder poly(multi)kristallinen Substanzen bestehen können. Beispielhaft wird auf das Buch "Solartechnik", Lippold, Ernst, Verlag für Architektur und technisches Wissen, Berlin 1984, verwiesen.

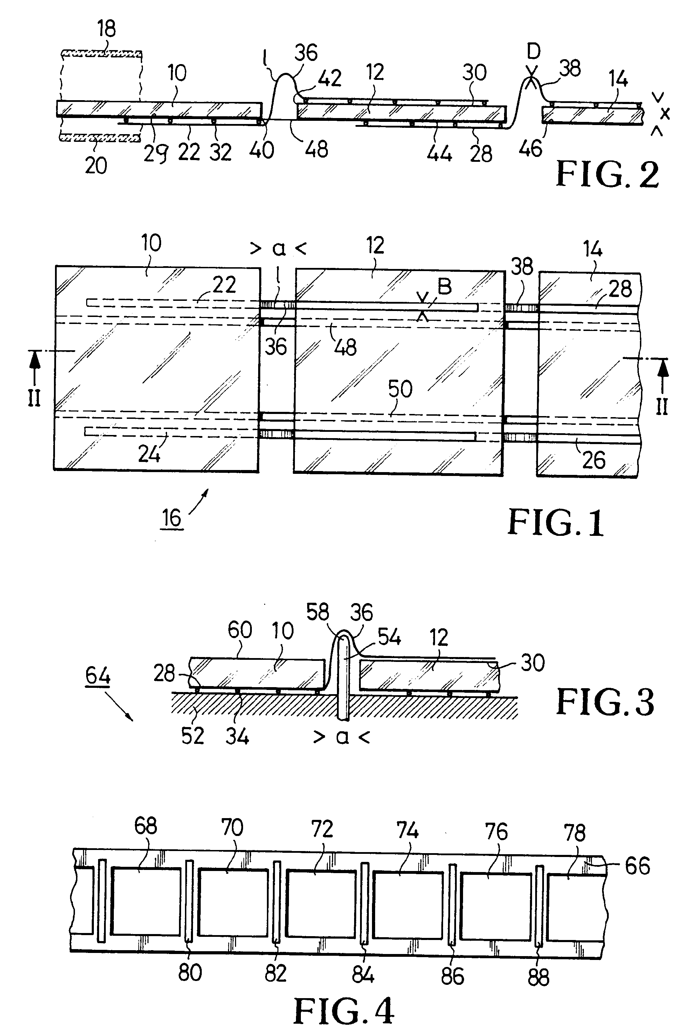

Entsprechende zu dem Solarzellenstring (16) in Reihe geschalteten Solarzellen (10), (12) und (14) werden ihrerseits zu einem Solarzellenmodul zusammengestellt, bei dem die Solarzellenstrings zwischen einer optisch durchlässigen Frontplatte (18) und einer rückseitigen Platte (20) angeordnet werde. Diese Platten (18) und (20) sind rein schematisch am linken Rand der Fig. 2 eingezeichnet. Der Zwischenraum zwischen den Platten (18) und (20) und den Solarzellen (10), (12) und (14) kann mit einem härtbaren, optisch voll transparenten Harz ausgegossen sein. Auch kann der Zwischenraum durch im Autoklaven auflaminierten Schmelzkleber ausgefüllt werden.

Um die Solarzellen (10) und (12) und (12) und (14) elektrisch in Reihe zu schalten, sind Kontaktstreifen (22) und (24) bzw. (26) und (28) vorgesehen. Diese verlaufen zwischen der Rückseite einer Solarzelle zu der Frontseite der benachbarten Solarzelle und umgekehrt.

Beispielhaft ist der Kontaktstreifen (22) mit der Rückseite (29) der Solarzelle (10) und mit der Frontseite (30) der Solarzelle (12) verbunden. Diese Verbindung erfolgt vorzugsweise durch punktuelles Ultraschallschweißen. Die Kontaktpunkte sind in den Fig. 2 und 3 rein schematisch eingezeichnet und beispielhaft mit dem Bezugszeichen (32) und (34) versehen.

Damit zwischen den benachbarten Solarzellen (10) und (12) bzw. (12) und (14) gefahrlos eine Relativbewegung bedingt durch z. B. den Transport des noch nicht zu einem Solarzellenmodul zusammengesetzten Solarzellenstrings, durch Wechselbelastungen auf Grund von Temperaturschwankungen oder durch mechanische Beanspruchungen des fertigen Solarzellenstrings (16) bzw. des Solarzellenmoduls selbst auftreten kann, weist der Kontaktstreifen (22), (24), (26), (28) zwischen den benachbarten Solarzellen (10) und (12) bzw. (12) und (14) einen kontrollierten, kurvenförmigen Verlauf auf. Der jeweilige kurvenförmige Verlauf ist mit den Bezugszeichen (36) und (38) versehen.

Vorzugsweise weist der zwischen den benachbarten Solarzellen (10) und (12) bzw. (12) und (14) verlaufende Abschnitt (36) bzw. (38) eine Länge 1 auf, die bei einem Abstand a der Solarzellen (10), (12) bzw. (12), (14) und einer Dicke x der Solarzellen (10), (12) und (14) mit x < a, vorzugsweise x < < a der Beziehung 1,5 a < 1 < 3a, vorzugsweise 1 ≈ 2a gehorcht.

Die Länge 1 ist dabei der Abstand zwischen den gegenüberliegenden Kanten (40) und (42) der benachbarten Solarzellen (10) und (12). Entsprechendes gilt für die Solarzellen (12) und (14).

Um den Transport der Solarzellen (10), (12) und (14) insbesondere nach dem Verschalten, also nachdem die Kontaktstreifen (22), (24), (26) und (28) mit den Solarzellen (10), (12) und (14) kontaktiert sind, zu erleichtern, verlaufen auf den Rückseiten (29) bzw. (44) bzw. (46) der Solarzellen Fixierstreifen wie Klebestreifen (46) und (48), die gleichzeitig zur Fixierung des fertigen Strings (16) im Solarzellenmodul dienen.

Damit die zwischen den Solarzellen (10) und (12) bzw. (12) und (14) verlaufenden Abschnitten (36) und (38) der Kontaktstreifen (22), (24), (26) und (28) die gewünschte Länge 1 aufweisen, sind Maßnahmen nötig, die anhand der Fig. 3 und 4 rein beispielhaft angedeutet sind.

In Fig. 3 sind in vergrößerter Darstellung Abschnitte der in Reihe zu schaltenden Solarzellen (10) und (12) dargestellt. Die Solarzellen (10) und (12) werden in dem Abstand a zueinander beabstandet auf einer Unterlage (52) angeordnet, und zwar zu beiden Seiten eines vorzugsweise als Nocken ausgebildeten Elementes (54), das mit seiner freien oberen Kante (58) über die Frontseiten (60) und (62) der Solarzellen (10) und (12) vorsteht. Über das Element (58) wird der Kontaktstreifen (22) gespannt, um sodann entlang der Oberseite (62) der Solarzelle (12) geführt und dort kontaktiert zu werden.

Die Höhe des über die freien Oberflächen (60) und (62) ragenden Abschnitts (58) des Elementes (56) gibt folglich die Länge 1 des Abschnittes (36) vor.

Um die Länge 1 individuell festlegen zu können, ist das Element (54) vorzugsweise höhenverstellbar ausgebildet. Auch kann das Element (54) vollständig in die Unterlage (52) versenkt werden, um die verschalteten Solarzellen (10) und (12) entlang der Unterlage (52) verschieben zu können.

Soll die Solarzelle (12) mit der nachfolgenden Solarzelle, also der Solarzelle (14) verschaltet werden, so wird die Solarzelle (12) in die Position der Solarzelle (10) bewegt, um sodann die von dieser ausgehenden Kontaktstreifen (26) und (28) auf der Frontseite der Solarzelle (14) zu kontaktieren, die dann die Position der in Fig. 3 gezeichneten Solarzelle (12) einnimmt.

In Fig. 4 ist eine alternative Anordnung (64) zum Verschalten von Solarzellen dargestellt. In einer Aufnahme (66) sind Vertiefungen wie Nester (68), (70), (72), (74), (76), (78) vorgesehen, die den Abmessungen der aufzunehmenden Solarzellen angepaßt sind. Zwischen aufeinanderfolgenden Vertiefungen (68), (70) bzw. (70), (72) bzw. (72), (74) bzw. (74), (76) bzw. (76), (78) sind Elemente (80), (82), (84), (86) und (88) angeordnet, die die Funktion des Elementes (54) der Fig. 3 erfüllen. Dabei können die Elemente (80), (82), (84), (86) und (88) sowohl höhenverstellbar als auch versenkbar ausgebildet sein.

Die Elemente (80), (83), (84), (86), (88) können nicht nur die Aufgabe erfüllen, die Länge der zwischen den zu verschaltenden Solarzellen verlaufenden Kontaktelemente vorzugeben, sondern können auch als Entnahmehilfe aus den Vertiefungen (68), (70), (72), (74), (76) und (78) dienen; denn nach dem die Kontaktelemente mit den Solarzellen kontaktiert sind, brauchen die Elemente (80), (82), (84), (86) und (88) nur weiter angehoben zu werden, um so mittels der entlang dieser geführten Kontaktstreifen die Solarzellen aus den Vertiefungen (68), (70), (72), (74), (76) und (78) anzuheben.

Als Kontaktelemente (22), (24), (26) und (28) kommen vorzugsweise Aluminiumbänder oder verzinnte Kupferbänder einer Dicke D von vorzugsweise 0,05 bis 0,2 mm, vorzugsweise von 0,1 mm bei einer Breite B von vorzugsweise 1 bis 2 mm, vorzugsweise von 2 mm infrage.

Bei den einzelnen Solarzellen (10), (12) und (14) einer Fläche von z. B. 10 x 10 cm² bedarf es vorzugsweise zweier Kontaktstreifen um benachbarte Solarzellen elektrisch in Reihe zu schalten. Hieraus ergibt sich ein prinzipieller Aufbau, wie er insbesondere durch die Fig. 1 angegeben ist.

## Patentansprüche

1. Vorrichtung zum Verschalten von in Reihen anzuordnenden und zueinander beabstandeten Solarzellen (10, 12, 14) zur Bildung eines Solarzellenstrings (16), wobei eine freie obere Seite (30, 60) einer Solarzelle mit einer unteren Seite (29, 44, 46) einer benachbarten Solarzelle mittels eines streifenförmigen, zwischen den Solarzellen kurvenförmig verlaufenden Kontaktelements (22, 24, 26, 28) elektrisch zu kontaktieren ist und wobei das Kontaktelement während des Kontaktierens zumindest bereichsweise an einem zwischen den Solarzellen anordbaren Element (54) anliegt, welches die freie obere Seite der Solarzellen überragt,
**dadurch gekennzeichnet,**
daß das Element (54) zwischen den Solarzellen (10, 12, 14) angeordnet und derart ausgebildet ist, daß beim Kontaktieren der Solarzellen (10, 12, 14) zur Erzielung eines kontrollierten kurvenförmigen Verlaufs (36, 38) gewünschter Länge das Kontaktelement (22, 24. 26, 28) während des Kontaktierens über das Element gespannt ist.

2. Vorrichtung nach Anspruch 1,
**dadurch gekennzeichnet,**
daß das Element (54) derart höhenverstellbar ausgebildet ist, daß die Länge des Kontaktelements (22, 24, 26, 28) zwischen den Solarzellen (10, 12, 14) in gewünschtem Umfang einstellbar ist.

3. Vorrichtung nach Anspruch 1 oder 2,
**dadurch gekennzeichnet,**
daß das Element (54) ein anhebbarer bzw. absenkbarer Nocken ist.

4. Vorrichtung nach zumindest einem der vorhergehenden Ansprüchen,
**dadurch gekennzeichnet,**
daß zu verschaltende Solarzellen (10, 12, 14) in einer eine Führung bildenden Vertiefung einer Aufnahme verschiebbar angeordnet sind.

5. Vorrichtung nach zumindest einem der vorhergehenden Ansprüchen,
**dadurch gekennzeichnet,**
daß einzelne Solarzellen (68, 70, 72, 74, 76 78) in jeweils angepaßten Aufnahmen angeordnet sind und daß zwischen zwei Aufnahmen jeweils ein den Verlauf von zumindest einem Kontaktelement vorgebendes Element (80, 82, 84, 86, 88) angeordnet ist.

6. Verfahren zur Herstellung eines Solarzellenstrings (16) umfassend zumindest zwei in Reihe geschaltete zueinander beabstandete Solarzellen (10, 12, 14), wobei streifenförmige Kontaktelemente (22, 24, 26, 28) mit der Rückseite (29, 44, 46) einer Solarzelle und der Vorderseite (30, 60) einer folgenden Solarzelle durch z.B. Ultraschallschweißung oder Löten elektrisch leitend dadurch kontaktiert werden, daß jede der zu verschaltenden Solarzellen auf der jeweils gleichen Seite mit jeweils zumindest einem Kontaktelement kontaktiert wird, daß die Solarzellen mit der das Kontaktelement aufweisenden Seite auf eine Unterlage (54) gelegt werden und daß das jeweilige mit der benachbarten Solarzelle zu kontaktierende Kontaktelement auf der zu kontaktierenden Seite der benachbarten Solarzelle angeordnet und anschließend kontaktiert wird, wobei das Kontaktelement zwischen den Solarzellen kurvenförmig verläuft und beim Kontaktieren mit an einem Element anliegt,
**dadurch gekennzeichnet,**
daß zur Erzielung eines kontrollierten kurvenförmigen Verlaufs des Kontaktelements gewünschter Länge zwischen den zu verschaltenden benachbarten Solarzellen beim Verschalten dieser ein die freien Vorderseiten (30, 60) der Solarzellen (10, 12, 14) überragendes Element (54, 80, 82, 84, 86 88) angeordnet wird, über das das Kontaktelement gespannt wird, und daß nach dem Verschalten der Solarzellen das Element aus dem Bereich zwischen den Solarzellen entfernt wird.

7. Verfahren nach Anspruch 6,
**dadurch gekennzeichnet,**
daß das Element (54) zur Erzielung einer gewünschten Länge (L) des zwischen den Solarzellen (10, 12, 14) verlaufenden und relativ zu diesen beweglichen Abschnitts des Kontaktelements (22, 24, 26, 28) höhenverstellt wird.

8. Verfahren nach Anspruch 7,
**dadurch gekennzeichnet**,
daß aufeinanderfolgend zu beiden Seiten des Elementes (54) zu verschaltende Solarzellen (10, 12) angeordnet werden, wobei die zuletzt verschaltete Solarzelle bei der nachfolgenden Verschaltung mit einer weiteren Solarzelle in die Position der zuvor verschalteten Solarzelle bewegt wird.

9. Verfahren nach zumindest einem der vorhergehenden Ansprüchen,
**dadurch gekennzeichnet,**
daß zu verschaltende Solarzellen (68, 70, 72, 74, 76, 78) in Vertiefungen einer Aufnahme (66) positioniert werden, wobei zwischen zwei Vertiefungen jeweils ein mit jeweils zumindest einem Kontaktelement wechselwirkendes Element (80, 82, 84, 86, 88) angeordnet wird, und daß gegebenenfalls die verschalteten Solarzellen aus den Vertiefungen durch Anheben der Elemente entfernt werden.

## Claims

1. Apparatus for interconnecting solar cells (10, 12, 14) that are spaced apart from one another and to be arranged in rows to form a solar cell string (16), such that a free upper surface (30, 60) of one solar cell is to be electrically connected to a lower surface (29, 44, 46) of an adjacent solar cell by means of a striplike contact element (22, 24, 26, 28) extending in a curve between the solar cells, and such that during connection, at least regions of the contact element rest against an element (54) which can be placed between the solar cells and projects beyond the free upper surface of the solar cells,
characterized in that
the element (54) is arranged between the solar cells (10, 12, 14) and is designed so that during connection of the solar cells (10, 12, 14), the contact element (22, 24, 26, 28) is tensioned by means of the element during connection in order to achieve a controlled curved path (36, 38) of a desired length.

2. Apparatus according to Claim 1,
characterized in that
the element (54) is designed to be adjustable in height in such a way that the length of the contact element (22, 24, 26, 28) between the solar cells (10, 12, 14) is adjustable to a desired degree.

3. Apparatus according to Claim 1 or 2,
characterized in that
the element (54) is a tappet that can be raised or lowered.

4. Apparatus according to at least one of the foregoing Claims,
characterized in that
solar cells (10, 12, 14) to be interconnected are arranged displaceably in a depression of a receptacle, which forms a guide.

5. Apparatus according to at least one of the foregoing Claims,
characterized in that
individual solar cells (68, 70, 72, 74, 76, 78) are each arranged in suitable receptacles; and that an element (80, 82, 84, 86, 88) which defines the path of at least one contact element is arranged between each two receptacles.

6. Method for producing a solar cell string (16) comprising at least two solar cells (10, 12, 14) spaced apart and connected in series with one another, such that striplike contact elements (22, 24, 26, 28) are electrically connected to the back surface (29, 44, 46) of one solar cell and the front surface (30, 60) of a subsequent solar cell by, for example, ultrasonic welding or soldering, in such a way that each of the solar cells being inter connected is connected, in each case on the same side, to at least one contact element; that the solar cells are laid with the side having the contact element on a substrate (54); and that the respective contact element to be connected to the adjacent solar cell is arranged on the side of the adjacent solar cell to be connected and is subsequently connected, such that the contact element extends in a curve between the solar cells and rests against an element during connection,
characterized in that
to achieve a controlled curved path of desired length for the contact element between the adjacent solar cells being interconnected when they are being interconnected, an element (54, 80, 82, 84, 86, 88) projecting beyond the free front surfaces (30, 60) of the solar cells (10, 12, 14) is arranged, by means of which the contact element is tensioned; and that after the solar cells are interconnected, the element is removed from the region between the solar cells.

7. Method according to Claim 6,
characterized in that
to achieve a desired length (L) for the section of the contact element (22, 24, 26, 28) which runs between the solar cells (10, 12, 14) and is movable relative to them, the element (54) is adjusted vertically.

8. Method according to Claim 7,
characterized in that
solar cells (10, 12) to be interconnected are arranged in succession on both sides of the element (54), such that the solar cell just interconnected is moved into the position of the previously interconnected solar cell when subsequently being interconnected to a further solar cell.

9. Method according to at least one of the foregoing Claims,
characterized in that
solar cells (68, 70, 72, 74, 76, 78) to be interconnected are positioned in depressions of a receptacle (66), such that an element (80, 82, 84, 86, 88) interacting in each case with at least one contact element is arranged between each two depressions; and that if applicable, the interconnected solar cells are removed from the depressions by raising the elements.

## Revendications

1. Dispositif de branchement de cellules solaires (10, 12, 14) à disposer en série et à placer à une certaine distance l'une de l'autre, pour former une suite de cellules solaires (16), dispositif dans lequel une face libre supérieure (30, 60) d'une cellule solaire doit être mise en contact électrique avec une face inférieure (29, 44, 46) d'une cellule solaire voisine au moyen d'un élément de contact (22, 24, 26, 28) en forme de ruban, se développant en une forme courbe et dans lequel l'élément de contact pendant la mise en contact repose au moins par secteur sur un élément (54) pouvant être mis en place entre les cellules solaires, élément qui dépasse au-dessus de la face supérieure libre des cellules solaires, caractérisé en ce que l'élément (54) est placé entre les cellules (10, 12, 14) et est réalisé, de façon que pour produire le contact entre les cellules et afin d'obtenir une allure (36, 38) courbe contrôlée de longueur souhaitée, l'élément de contact (22, 24, 26, 28) est mis en tension sur l'élément (54) pendant l'établissement du contact.

2. Dispositif selon la revendication 1, caractérisé en ce que l'élément (54) est réalisé réglable en hauteur, de façon à pouvoir ajuster la longueur de l'élément de contact (22, 24, 26, 28) entre les cellules dans un volume souhaité.

3. Dispositif selon les revendications 1 ou 2, caractérisé en ce que l'élément (54) est un ergot soulevable ou abaissable.

4. Dispositif selon au moins une des revendications précédentes, caractérisé en ce que les cellules solaires (10, 12, 14) à brancher sont disposées en étant susceptibles de coulisser dans un évidement de réception formant guidage.

5. Dispositif selon au moins une des revendications précédentes, caractérisé en ce que des cellules solaires individuelles (68, 70, 72, 74, 76, 78) sont placées dans des logements adaptés à chacune d'elle et en ce que, entre deux évidemments, un élément (80, 82, 84, 86, 88) est respectivement placé, définissant le profil d'au moins un élément de contact.

6. Procédé de fabrication d'une suite de cellules solaires (16) comprenant au moins deux cellules solaires (10, 12, 14) montées en série à une certaine distance l'une de l'autre, procédé dans lequel des éléments de contact (22, 24, 26, 28) en forme de ruban sont mis en contact de conductibilité électrique avec la face arrière (29, 44, 46) d'une cellule solaire et la face avant (30, 60) d'une cellule solaire suivante par exemple par soudure aux ultrasons ou brasage, du fait que chacune des cellules solaires à brancher est mise en contact respectivement avec au moins un élément de contact au moins sur la même face, en ce que les cellules solaires sont posées sur une base (54) par leur face comportant l'élément de contact et que l'élément de contact respectif à mettre en contact avec la cellule solaire voisine est d'abord placé sur la face à connecter de la cellule solaire voisine et ensuite est mis en contact, l'élément de contact, se développant en forme de courbe entre les cellules solaires, adhère lors de la mise en contact sur un élément, caractérisé en ce que, pour obtenir un profil en courbe contrôlé de l'élément de contact de longueur souhaitée entre les cellules solaires voisines à brancher lors de leur montage, on place un élément (54, 80, 82, 84, 86, 88) dépassant au-dessus des faces avant libres (30, 60) des cellules solaires (10, 12, 14), élément sur lequel est serré l'élément de contact et en ce qu'après le branchement des cellules solaires, l'élément est éloigné de la zone située entre les cellules solaires.

7. Procédé selon la revendication 6, caractérisé en ce que l'élément (54) est réglable en hauteur pour obtenir une longueur (L) désirée du tronçon de l'élément de contact (22, 24, 26, 28) se développant entre les cellules solaires (10, 12, 14) et mobile par rapport à celles-ci.

8. Procédé selon la revendication 7, caractérisé en ce que des cellules solaires à brancher (10, 12) sont placées à la suite l'une de l'autre des deux côtés de l'élément (54), la cellule solaire branchée la dernière est déplacée, lors du montage suivant avec une autre cellule solaire, dans la position de la cellule solaire branchée auparavant.

9. Procédé selon au moins une des revendications précédentes, caractérisé en ce que des cellules solaires à brancher (68, 70, 72, 74, 76, 78) sont positionnées dans des évidements de réception (66), dans lequel est placé entre deux évidements respectivement un élément (80, 82, 84, 86, 88) interagissant respectivement au moins avec un élément de contact et en ce que, éventuellement, les cellules solaires branchées sont enlevées de leurs évidements par suite du soulèvement des éléments.
